# EUROPÄISCHE PATENTSCHRIFT

(11) **EP 1 071 961 B1**
(45) Veröffentlichungstag und Bekanntmachung des Hinweises auf die Patenterteilung: **31.07.2002**
(21) Anmeldenummer: 99927709.8
(22) Anmeldetag: 16.04.1999
(51) Int. Cl.: G01R 31/02, H02H 3/28

(54) **ANORDNUNG, VERFAHREN UND STROMMESSEINRICHTUNG ZUM MESSEN EINES STROMES IN EINER LEITUNG**
LAYOUT, METHOD AND CURRENT MEASURING DEVICE FOR MEASURING A CURRENT IN A CONDUCTOR
DISPOSITIF, PROCEDE ET INSTALLATION DE MESURE DE COURANT SERVANT A MESURER UN COURANT DANS UN CONDUCTEUR

(30) Priorität: 17.04.1998 DE 19817940
(43) Veröffentlichungstag der Anmeldung: 31.01.2001
(73) Patentinhaber: SIEMENS AKTIENGESELLSCHAFT, 80333 München (DE)
(72) Erfinder: PHILIPPOT, Luc, D-14656 Brieselang (DE); SCHUSTER, Norbert, D-91301 Forchheim (DE)
(86) Internationale Anmeldenummer: DE9901212
(87) Internationale Veröffentlichungsnummer: WO9954742

(56) Entgegenhaltungen:
- DE-A- 19 630 989
- US-A- 4 862 308

## Beschreibung

Aus der US-PS 4,862,308 ist ein Schutzsystem bekannt, bei dem in Abzweigleitungen von einer Sammelschiene fließende Ströme. jeweils für sich erfaßt und als Strommeßwerte jeweils für sich zu einer zentralen Meßwertverarbeitungseinrichtung übertragen werden, in der aus den einzelnen Strommeßwerten in eine Strommeßeinrichtung eine der Differenz aller übertragenen Strommeßwerte proportionale Spannung für einen Fehlerdetektor erzeugt wird.

Der Erfindung liegt die Aufgabe zugrunde, ein besonders einfach durchführbares Verfahren zum Erzeugen eines Signals anzugeben, das einen Fehlerstrom in einem mindestens drei Leiterenden aufweisenden elektrischen Leiter kennzeichnet. Unter einem Fehlerstrom wird dabei ein Strom verstanden, der an einer Fehlerstelle des Leiters, beispielsweise einer Kurzschlußstelle, also nicht an einem der Leiterenden aus dem Leiter abfließt bzw. in den Leiter, hineinfließt.

Zur Lösung dieser Aufgabe wird erfindungsgemäß vorgeschlagen ein Verfahren zum Erzeugen eines einen Fehlerstrom eines mindestens drei Leiterenden aufweisenden elektrischen Leiters kennzeichnenden Fehlersignals mit Strommeßeinrichtungen, die derart angeordnet sind, daß an jedem Leiterende des Leiters eine der Strommeßeinrichtungen angebracht ist und die Strommeßeinrichtungen über Datenleitungen verbunden sind, wobei bei dem Verfahren mit den Strommeßeinrichtungen der Strom in den jeweiligen Leiterenden unter Bildung von Strommeßwerten gemessen wird, zu einer ausgewählten Strommeßeinrichtung ein Meßwert übertragen wird, der aus den Strommeßwerten der übrigen Strommeßeinrichtungen durch vorzeichenrichtige Addition gebildet ist, und mit der ausgewählten Strommeßeinrichtung aus ihren Strommeßwerten und dem Meßwert ein Gesamtstromwert durch vorzeichenrichtige Addition gebildet wird und mit der ausgewählten Strommeßeinrichtung das Fehlersignal erzeugt wird, wenn der Gesamtstromwert betragsmäßig einen vorgegebenen Schwellenwert überschreitet. Die vorzeichenrichtige Addition der Strommeßwerte kann dabei im Zeitbereich oder im Frequenzbereich erfolgen. Wird das erfindungsgemäße Verfahren in einem dreiphasigen Wechselstromsystem eingesetzt, so muß das Verfahren für jede Phase, d.h. für jeden Phasenleiter, separat durchgeführt werden; dabei kann im Falle eines Fehlerstroms jede Phase einzeln abgeschaltet werden.

Es ist zwar aus der DE 196 30 989 A1 eine Differentialschutzanordnung bekannt, bei der ein Meßwert übertragen wird, der aus Stromwerten von mehreren Strommeßeinrichtungen gebildet ist, jedoch wird hierbei ein aus den Stromwerten sämtliche Strommeßeinrichtungen gebildeter Meßwert übertragen zu einer Auswerteeinrichtung. Als Strommeßeinrichtungen sind optische Sensoren erforderlich, weil die Bildung des Meßwertes mittels eines gemeinsamen optischen Leiters erfolgt.

Der wesentliche Vorteil des erfindungsgemäßen Verfahrens besteht darin, daß es sehr schnell ist; denn bei dem erfindungsgemäßen Verfahren werden die Strommeßwerte der übrigen Strommeßeinrichtungen zuerst durch vorzeichenrichtige Addition zu einem Meßwert zusammengefaßt, und es wird anschließend nur dieser Meßwert zu der ausgewählten Strommeßeinrichtung übertragen. Da nur dieser einzige Meßwert zu der ausgewählten Strommeßeinrichtung übertragen werden muß, ist die gesamte zu übertragende Datenmenge sehr klein; dies führt zu der besonders hohen Geschwindigkeit des erfindungsgemäßen Verfahrens; denn je weniger Daten übertragen werden müssen, um so weniger Zeit ist dafür erforderlich. Darüber hinaus muß in der ausgewählten Strommeßeinrichtung nur ein einziger Rechenschritt durchgeführt werden, der darin besteht, den übertragenen Meßwert zu dem gemessenen Strommeßwert der ausgewählten Strommeßeinrichtung zu addieren; durch das Übermitteln des vorab bestimmten Meßwertes wird die ausgewählte Strommeßeinrichtung also von weiteren Rechenschritten entlastet, was ebenfalls zu einem Geschwindigkeitsgewinn führt.

Die eingangs genannte Aufgabe wird erfindungsgemäß auch gelöst durch ein Verfahren zum Erzeugen eines einen Fehlerstrom eines mindestens drei Leiterenden aufweisenden elektrischen Leiters kennzeichnenden Fehlersignals mit Strommeßeinrichtungen, die derart angeordnet sind , daß an jedem Leiterende des Leiters eine der Strommeßeinrichtungen angebracht ist und die Strommeßeinrichtungen über Datenleitungen verbunden sind, wobei bei dem Verfahren mit den Strommeßeinrichtungen der Strom in den jeweiligen Leiterenden unter Bildung von Strommeßwerten gemessen wird, zu einer ausgewählten Strommeßeinrichtung ein Meßwert übertragen wird, der aus den Strommeßwerten einer ersten Gruppe der übrigen Strommeßeinrichtungen durch vorzeichenrichtige Addition gebildet ist, zu der ausgewählten Strommeßeinrichtung ein weiterer Meßwert übertragen wird, der aus den Strommeßwerten einer zweiten Gruppe der übrigen Strommeßeinrichtungen durch vorzeichenrichtige Addition gebildet ist, wobei die zweite Gruppe alle Strommeßeinrichtungen außer der ausgewählten und den Strommeßeinrichtungen der ersten Gruppe enthält, mit der ausgewählten Strommeßeinrichtung aus ihren Strommeßwerten und den beiden Meßwerten ein Gesamtstromwert durch vorzeichenrichtige Addition gebildet wird und mit der ausgewählten Strommeßeinrichtung das Fehlersignal erzeugt wird, wenn der Gesamtstromwert betragsmäßig einen vorgegebenen Schwellenwert überschreitet. Die im Zusammenhang mit dem ersten erfindungsgemäßen Verfahren genannten Vorteile gelten auch für das zweite erfindungsgemäße Verfahren; ein besonderer Vorteil des zweiten Verfahrens besteht darin, daß bei diesem die Strommeßeinrichtungen in zwei Gruppen unterteilt werden können und für jede der beiden Gruppen ein separater Meßwert gebildet werden kann. Dies kann beispielsweise von Vorteil sein, wenn die zwei Gruppen von Strommeßeinrichtungen räumlich sehr weit voneinander getrennt liegen und das Bilden und Übertragen eines einzigen Meßwertes zu der ausgewählten Strommeßeinrichtung einen besonders hohen Aufwand hervorrufen würde.

Im Rahmen der Erfindung wird außerdem eine Anordnung vorgeschlagen, mit der sich ein einen Fehlerstrom in einem mindestens drei Leiterenden aufweisenden elektrischen Leiter kennzeichnendes Fehlersignal besonders einfach bilden läßt.

Diese Aufgabe wird erfindungsgemäß gelöst durch eine Anordnung zum Erzeugen eines einen Fehlerstrom eines mindestens drei Leiterenden aufweisenden elektrischen Leiters kennzeichnenden Fehlersignals mit an jedem Leiterende des Leiters jeweils einer angebrachten Strommeßeinrichtung, die den Strom in ihrem jeweiligen Leiterende unter Bildung eines Strommeßwertes mißt, wobei bei der Anordnung die Strommeßeinrichtungen elektrisch mittels Datenleitungen in einer kettenförmigen Struktur derart untereinander verbunden sind, daß jede in der Kette innenliegende Strommeßeinrichtung mit einem Meßwerteingang an einen Meßwertausgang der ihr jeweils vorgeordneten Strommeßeinrichtung und mit einem Meßwertausgang an einen Meßwerteingang der ihr jeweils nachgeordneten Strommeßeinrichtung angeschlossen ist und eine erste der beiden in der Kette außenliegenden Strommeßeinrichtungen mit ihrem Meßwertausgang an einen Meßwerteingang der ihr nachgeordneten innenliegenden strommeßeinrichtung angeschlossen ist und die zweite der beiden außenliegenden Strommeßeinrichtungen mit einem Meßwerteingang an den Meßwertausgang der ihr vorgeordneten innenliegenden Strommeßeinrichtung angeschlossen ist, jede innenliegende Strommeßeinrichtung eine Recheneinheit aufweist, die ihren Strommeßwert zu einem an ihrem Meßwerteingang anliegenden Meßwert der jeweils vorgeordneten Strommeßeinrichtung vorzeichenrichtig unter Bildung eines Summenstrommeßwertes addiert und den Summenstrommeßwert an ihrem Meßwertausgang als Meßwert abgibt, die zweite außenliegende Strommeßeinrichtung eine Steuereinheit aufweist, die das Fehlersignal abgibt, sobald ein aus dem Meßwert der vorgeordneten innenliegenden Strommeßeinrichtung und ihrem Strommeßwert durch vorzeichenrichtige Addition gebildeter Gesamtstromwert einen vorgegebenen Schwellenwert überschreitet. Der wesentliche Vorteil dieser Anordnung besteht in der besonders großen Geschwindigkeit, mit der das Fehlersignal erzeugt wird, da zu der zweiten außenliegenden Strommeßeinrichtung nicht alle Strommeßwerte der übrigen Strommeßeinrichtungen einzeln übertragen werden, sondern statt dessen nur ein einziger Meßwert, der die Stromsumme der übrigen Strommeßeinrichtungen enthält; dies führt zu einem besonders schnellen Erzeugen des Fehlersignals, weil die gesamte, zu der zweiten außenliegenden Strommeßeinrichtung zu übertragende Datenmenge relativ gering ist, da nur ein einziger Meßwert zu übertragen ist. Ein weiterer Vorteil der erfindungsgemäßen Anordnung besteht darin, daß nur relativ wenige Datenleitungen zur Verbindung der Strommeßeinrichtungen notwendig sind; bei einer Leitung mit N Leiterenden sind bei der erfindungsgemäßen kettenförmigen Anordnung der Strommeßeinrichtungen lediglich (N-1) Datenleitungen erforderlich, wohingegen bei einer Anordnung, bei der alle Strommeßeinrichtungen untereinander verbunden sind, N*(N-1) Datenleitungen benötigt werden.

Um zu erreichen, daß zusätzlich zu der zweiten außenliegenden Strommeßeinrichtung auch mindestens eine innenliegende Strommeßeinrichtung das Fehlersignal erzeugen kann, wird im Rahmen einer Weiterbildung der erfindungsgemäßen Anordnung erfindungsgemäß vorgeschlagen, daß die innenliegenden Strommeßeinrichtungen untereinander derart verbunden sind, daß ein weiterer Meßwerteingang einer innenliegenden Strommeßeinrichtung an einen weiteren Meßwertausgang der ihr jeweils nachgeordneten innenliegenden Strommeßeinrichtung und ein weiterer Meßwertausgang einer innenliegenden Strommeßeinrichtung an einen weiteren Meßwerteingang der ihr jeweils vorgeordneten innenliegenden Strommeßeinrichtung angeschlossen ist, die erste außenliegende Strommeßeinrichtung mit einem Meßwerteingang an einen weiteren Meßwertausgang der ihr nachgeordneten innenliegenden Strommeßeinrichtung angeschlossen ist und die zweite außenliegende Strommeßeinrichtung mit einem Meßwertausgang an einen weiteren Meßwerteingang der ihr vorgeordneten innenliegenden Strommeßeinrichtung angeschlossen ist, jede innenliegende Strommeßeinrichtung eine weitere Recheneinheit aufweist, die den Strommeßwert der eigenen Strommeßeinrichtung zu einem an ihrem weiteren Meßwerteingang anliegenden weiteren Meßwert der nachgeordneten Strommeßeinrichtung vorzeichenrichtig unter Bildung eines weiteren Summenstrommeßwertes addiert und den resultierenden weiteren Summenstrommeßwert an ihrem weiteren Meßwertausgang als weiteren Meßwert abgibt, und mindestens eine der inneren Strommeßeinrichtungen eine Steuereinheit aufweist, die das Fehlersignal erzeugt, sobald der aus den an ihren beiden Meßwerteingängen anliegenden Meßwerten und ihrem gemessenen Strommeßwert durch vorzeichenrichtige Addition gebildete Gesamtstromwert den vorgegebenen Schwellenwert überschreitet. Der Vorteil dieser Anordnung besteht darin, daß mehrere Strommeßeinrichtungen der Anordnung in der Lage sind, das Fehlersignal zu erzeugen, da alle Strommeßeinrichtungen über die erforderlichen Strominformationen verfügen; bei einer solchen Anordnung sind dann 2*(N-1) Datenleitungen erforderlich.

Um zu erreichen, daß auch mit der ersten außenliegenden Strommeßeinrichtung das Fehlersignal erzeugt werden kann, wird erfindungsgemäß vorgeschlagen, daß die erste außenliegende Strommeßeinrichtung eine Steuereinheit aufweist, die das Fehlersignal erzeugt, sobald der aus dem an ihrem Meßwerteingang anliegenden Meßwert und ihrem gemessenen Strommeßwert durch vorzeichenrichtige Addition gebildete Gesamtstromwert den vorgegebenen Schwellenwert überschreitet.

Eine besonders hohe Zuverlässigkeit kann bei der erfindungsgemäßen Anordnung erreicht werden, wenn die beiden außenliegenden Strommeßeinrichtungen durch mindestens eine zusätzliche Datenleitung miteinander verbunden sind, über die der Gesamtstromwert übertragen wird. Bei einer solchen Anordnung kann nämlich zwischen den beiden außenliegenden Strommeßeinrichtungen der jeweils ermittelte Gesamtstromwert zu Kontrollzwecken übertragen werden; beispielsweise können die beiden außenliegenden Strommeßeinrichtungen die Funktionstüchtigkeit der gesamten Anordnung überprüfen, indem sie ihre jeweiligen Gesamtstromwerte vergleichen. Ein weiterer Vorteil der zusätzlichen Datenleitung besteht darin, daß die erfindungsgemäße Anordnung auch dann weiterbetrieben werden kann, wenn eine der Datenleitungen durch eine Störung unterbrochen ist.

Im Rahmen der Erfindung wird auch eine Strommeßeinrichtung vorgeschlagen, die sich bei den erfindungsgemäßen Verfahren bzw. bei der erfindungsgemäßen Anordnung einsetzen läßt. Dabei handelt es sich um eine Strommeßeinrichtung zum Messen eines Stromes in einem Leiter mit mindestens einem Meßwerteingang und mindestens einem Meßwertausgang sowie einer Recheneinheit, die einen dem Strom entsprechenden Strommeßwert zu einem an dem mindestens einen Meßwerteingang anliegenden Strommeßwert addiert und den resultierenden Summenstrommeßwert an dem mindestens einen Meßwertausgang abgibt. Der wesentliche Vorteil der erfindungsgemäßen Strommeßeinrichtung besteht darin, daß sie eine Recheneinheit aufweist, mit der beispielsweise Summenstrommeßwerte gebildet werden können, wie sie im Zusammenhang mit dem erfindungsgemäßen Verfahren bzw. mit der erfindungsgemäßen Anordnung bereits erläutert wurden. Die im Zusammenhang mit dem Verfahren und der Anordnung erläuterten Vorteile gelten damit für die erfindungsgemäße Strommeßeinrichtung sinnentsprechend.

Um die Installation der erfindungsgemäßen Strommeßeinrichtung zu erleichtern, wird im Rahmen einer Weiterbildung der erfindungsgemäßen Strommeßeinrichtung vorgeschlagen, daß die Recheneinheit eine Einrichtung aufweist, mit der das Vorzeichen des Strommeßwertes geändert werden kann. Eine solche Strommeßeinrichtung weist den Vorteil auf, daß beim Anschluß der Strommeßeinrichtung an einen Leiter bzw. an ein Leiterende nicht auf die Stromrichtung des Stromes im Leiter bzw. Leiterende geachtet werden muß, weil das Vorzeichen des von der Strommeßeinrichtung ermittelten Strommeßwertes ggf. - sozusagen nachträglich - geändert werden kann. Dies ist beispielsweise im Hinblick auf die vorzeichenrichtige Addition der Strommeßwerte beim erfindungsgemäßen Verfahren zum Erzeugen eines Fehlersignals von Bedeutung, da bei der Bildung eines Summenstrommeßwertes die Vorzeichen natürlich zu beachten sind.

Soll mit der erfindungsgemäßen Strommeßeinrichtung darüber hinaus auch ein Fehlersignal gebildet werden, so wird es als vorteilhaft angesehen, wenn die Strommeßeinrichtung eine Steuereinheit aufweist, die ein Signal für einen Fehlerstrom abgibt, sobald der Summenstrommeßwert einen vorgegebenen Schwellenwert überschreitet.

Zur Erläuterung der Erfindung zeigt
Figur 1 ein Ausführungsbeispiel für eine Anordnung zur Durchführung des erfindungsgemäßen Verfahrens,
Figur 2 ein Ausführungsbeispiel für eine erfindungsgemäße Anordnung und
Figur 3 ein Ausführungsbeispiel für eine erfindungsgemäße Strommeßeinrichtung mit einer Recheneinheit und einer Steuereinheit.

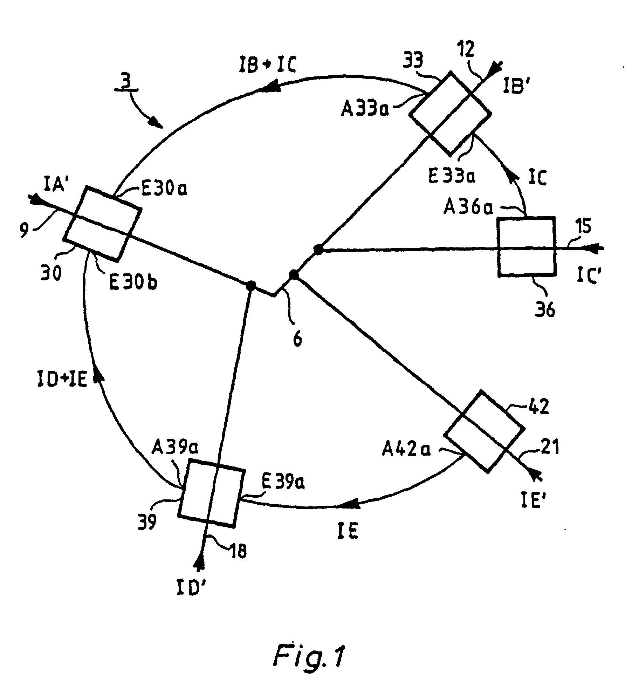

Figur 1 zeigt eine Anordnung 3 zum Überwachen eines elektrischen Leiters 6 auf einen Fehlerstrom. Der elektrische Leiter 6 weist insgesamt fünf Leiterenden auf, und zwar ein erstes Leiterende 9, ein zweites Leiterende 12, ein drittes Leiterende 15, ein viertes Leiterende 18 sowie ein fünftes Leiterende 21. An jedem der Leiterenden 9, 12, 15, 18 und 21 ist jeweils eine Strommeßeinrichtung angebracht, wobei die Strommeßeinrichtungen über Datenleitungen - beispielsweise optische Glasfasern - miteinander verbunden sind. Dabei ist an das erste Leiterende 9 eine ausgewählte erste Strommeßeinrichtung 30 und an die übrigen Leiterenden 12, 15, 18 und 21 jeweils eine weitere Strommeßeinrichtung 33, 36, 39 und 42 angeschlossen.

Konkret ist die erste Strommeßeinrichtung 30 mit Ihrem Meßwerteingang E30a mit einem Meßwertausgang A33a der ersten weiteren Strommeßeinrichtung 33 - im weiteren kurz als zweite Strommeßeinrichtung 33 bezeichnet - verbunden. Dieser ist an einem Meßwerteingang E33a die zweite der weiteren Strommeßeinrichtungen 36 - im weiteren kurz als dritte Strommeßeinrichtung 36 bezeichnet - mit Ihrem Meßwertausgang A36a vorgeordnet.

Die erste Strommeßeinrichtung 30 ist außerdem mit einem weiteren Meßwerteingang E30b mit einem Meßwertausgang A39a der dritten der weiteren Strommeßeinrichtungen 39 - im weiteren kurz als vierte Strommeßeinrichtung 39 bezeichnet - verbunden. Dieser ist an einem Meßwerteingang E39a die vierte der weiteren Strommeßeinrichtungen 42 - im weiteren kurz als fünfte Strommeßeinrichtung 42 bezeichnet - mit Ihrem Meßwertausgang A42a vorgeordnet.

Die fünf Strommeßeinrichtungen 30, 33, 36, 39 und 42 sind also in einer kettenförmigen Struktur untereinander verbunden, wobei die dritte Strommeßeinrichtung 36 und die fünfte Strommeßeinrichtung 42 in der Kette außenliegende Strommeßeinrichtungen und die erste Strommeßeinrichtung 30, die zweite Strommeßeinrichtung 33 und die vierte Strommeßeinrichtung 39 in der Kette innenliegende Strommeßeinrichtungen bilden.

Mit der Anordnung 3 wird der elektrische Leiter 6 in nachfolgend beschriebener Weise auf einen Fehlerstrom hin überwacht.

Mit einem nicht dargestellten Taktgenerator wird an alle Strommeßeinrichtungen ein Taktsignal übermittelt. Mit diesem Taktsignal wird sichergestellt, daß alle Strommeßeinrichtungen den jeweiligen Strom in ihrem Leiterende jeweils zu gleichen Zeitpunkten ermitteln.

Nachdem nun von allen Strommeßeinrichtungen zu einem Zeitpunkt die Ströme IA',..., IE' in den jeweiligen Leiterenden 9, 12, 15, 18, 21 gemessen wurden, wird wie folgt vorgegangen:

Der dem Strom IC' im Leiterende 15 entsprechende Strommeßwert IC der dritten Strommeßeinrichtung 36 wird am Meßwertausgang A36a der dritten Strommeßeinrichtung 36 abgegeben und zum Meßwerteingang E33a der zweiten Strommeßeinrichtung 33 übertragen. Diese zweite Strommeßeinrichtung 33 addiert zu dem dem durch ihr Leiterende 12 fließenden Strom IB' entsprechenden Strommeßwert IB den von der dritten Strommeßeinrichtung 36 übertragenen Strommeßwert IC unter Bildung eines Summenstrommeßwertes IC+IB mit einer in der Figur 1 nicht dargestellten Recheneinheit. Dieser Summenstrommeßwert IC+IB wird von der zweiten Strommeßeinrichtung 33 zu der ersten Strommeßeinrichtung 30 übertragen.

Die fünfte Strommeßeinrichtung 42 am fünften Leiterende 21 sowie die vierte Strommeßeinrichtung 39 am vierten Leiterende 18 arbeiten genauso wie die zweite und die dritte Strommeßeinrichtung, d. h., daß sie jeweils den Strommeßwert der eigenen Strommeßeinrichtung zu einem an Ihrem Meßwerteingang anliegenden Strommeßwert der ggf. jeweils vorgeordneten Strommeßeinrichtung unter Berücksichtigung der jeweiligen Stromrichtung vorzeichenrichtig addieren und den resultierenden Summenstrommeßwert an ihrem Meßwertausgang als Meßwert abgeben.

Zu dem einen Meßwerteingang E30a der ersten Strommeßeinrichtung 30 gelangt also ein Meßwert, der sich aus den Strommeßwerten IB und IC zusammensetzt, und zu dem weiteren Meßwerteingang E30b der ersten Strommeßeinrichtung 30 gelangt ein weiterer Meßwert, der sich aus den Strommeßwerten IE und ID zusammensetzt.

In der ersten Strommeßeinrichtung 30 wird daraufhin durch Addition des einen und des weiteren Meßwertes sowie des den Strom IA' im Leiterende 9 angebenden Strommeßwertes IA ein Gesamtstromwert gebildet; dieser Gesamtstromwert ist gleich IA+IB+IC+ID+IE.

Der Gesamtstromwert IA+IB+...+IE muß den Kirchhoff'schen Gesetzen zufolge gleich Null sein, wenn kein Fehlerstrom aufgetreten ist; ist der Gesamtstromwert ungleich Null bzw. überschreitet er einen vorgegebenen Schwellenwert, so ist ein Fehlerstrom aufgetreten. Unter einem Fehlerstrom wird dabei ein Strom verstanden, der an einer Fehlerstelle, beispielsweise einer Kurzschlußstelle, also nicht an einem der Leiterenden 9,12,15,18 bzw. 21 von dem Leiter 6 abfließt oder in den Leiter 6 eingespeist wird. Beide Arten von Fehlerströmen schlagen sich in dem Gesamtstromwert der Strommeßeinrichtung 30 nieder, was durch Vergleich des Gesamtstromwertes mit dem Schwellenwert, der ungefähr gleich Null ist, festgestellt werden kann.

Zusammenfassend wird also anhand des Gesamtstromwertes in der ausgewählten, ersten Strommeßeinrichtung 30 durch Vergleich mit dem Schwellenwert festgestellt, ob ein Fehlerstrom aufgetreten ist; dabei läßt sich beispielsweise in einem Gleichstromsystem nicht nur feststellen, ob überhaupt ein Fehler aufgetreten ist, sondern zusätzlich natürlich auch, welcher Art der Fehler ist, wenn nach dem Betragsvergleich des Gesamtstromwertes mit dem vorgegebenem Schwellenwert noch zusätzlich das jeweilige Vorzeichen des Gesamtstromwertes ausgewertet wird. Das Vorzeichen gibt nämlich - je nach seiner Zuordnung zu einer Stromrichtung an - , ob der Fehlerstrom in den Leiter 6 hinein- oder herausgeflossen ist.

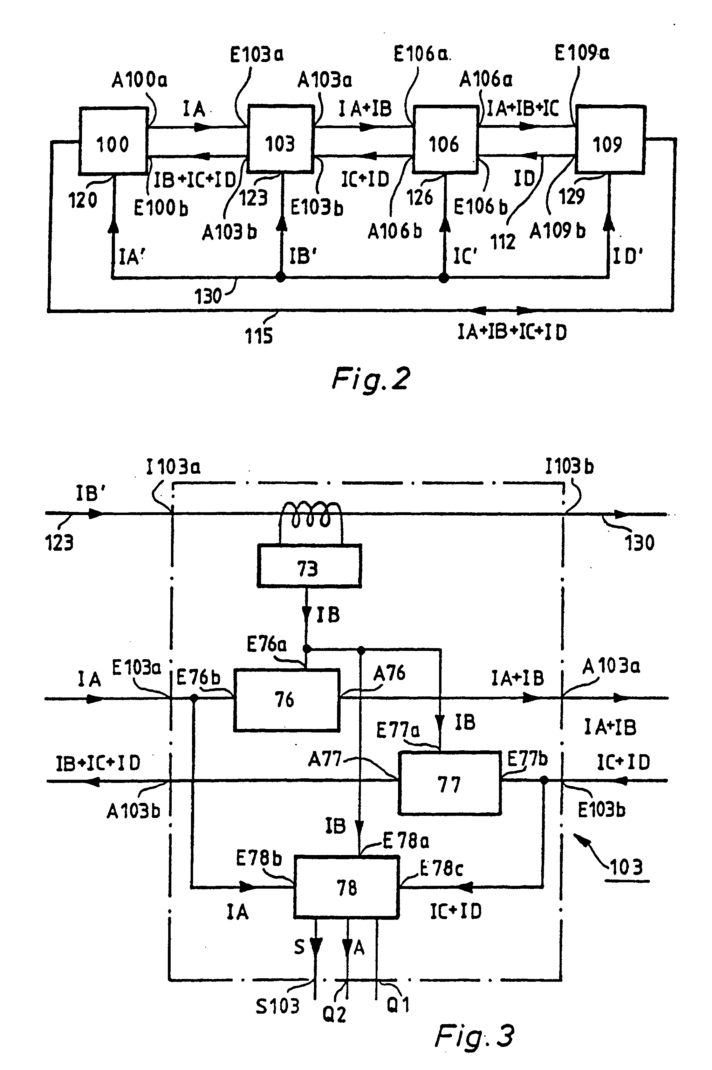

Figur 2 zeigt ein Ausführungsbeispiel für die erfindungsgemäße Anordnung. Man erkennt Strommeßeinrichtungen 100, 103, 106 und 109, die elektrisch mittels Datenleitungen 112 in einer kettenförmigen Struktur untereinander verbunden sind; dabei liegen zwei Strommeßeinrichtungen, und zwar die Strommeßeinrichtungen 100 und 109, am äußeren Ende der Kette und zwei Strommeßeinrichtungen, und zwar die Strommeßeinrichtungen 103 und 106, im Innern der Kette.

Die erste innenliegende Strommeßeinrichtung 103 ist mit ihrem Meßwerteingang E103a mit einem Meßwertausgang A100a der ihr vorgeordneten Strommeßeinrichtung 100 verbunden. Der ersten innenliegenden Strommeßeinrichtung 103 ist an ihrem Meßwertausgang A103a ein Meßwerteingang E106a der zweiten innenliegenden Strommeßeinrichtung 106 nachgeordnet, der wiederum an ihrem Meßwertausgang A106a ein Meßwerteingang E109a der zweiten außenliegenden Strommeßeinrichtung 109 nachgeschaltet ist. Die zweite außenliegende Strommeßeinrichtung 109 weist außerdem einen Meßwertausgang A109b auf, der mit einem weiteren Meßwerteingang E106b der zweiten innenliegenden Strommeßeinrichtung 106 verbunden ist; diese zweite innenliegende Strommeßeinrichtung 106 ist mit einem weiteren Meßwertausgang A106b außerdem an einen weiteren Meßwerteingang E103b der ersten innenliegenden Strommeßeinrichtung 103 angeschlossen. Mit einem weiteren Meßwertausgang A103b ist diese erste innenliegende Strommeßeinrichtung 103 auch mit einem Meßwerteingang E100b der ersten außenliegenden Strommeßeinrichtung 100 verbunden.

Außerdem besteht eine weitere Datenleitung 115, und zwar eine Duplexleitung, zwischen der ersten außenliegenden Strommeßeinrichtung 100 und der zweiten außenliegenden Strommeßeinrichtung 109.

Jede der Strommeßeinrichtungen 100, 103, 106 und 109 ist darüber hinaus jeweils an ein Leiterende des vier Leiterenden 120, 123, 126 und 129 aufweisenden elektrischen Leiters 130 - in der Figur 2 nur schematisch angedeutet - angeschlossen und mißt den an ihrem Leiterende fließenden Strom IA', IB', IC' oder ID' unter Bildung von Strommeßwerten IA, IB, IC oder ID; dabei mißt die erste außenliegende Strommeßeinrichtung 100 den Strommeßwert bzw. die Strommeßwerte IA am ersten Leiterende 120, die erste innenliegende Strommeßeinrichtung 103 den Strommeßwert bzw. die Strommeßwerte IB am zweiten Leiterende 123, die zweite innenliegende Strommeßeinrichtung 106 den Strommeßwert bzw. die Strommeßwerte IC am dritten Leiterende 126 und die zweite außenliegende Strommeßeinrichtung 109 den Strommeßwert bzw. die Strommeßwerte ID am vierten Leiterende 129.

Die Anordnung gemäß Figur 2 wird wie folgt betrieben: Der mit der ersten außenliegenden Strommeßeinrichtung 100 gemessene Strommeßwert IA wird zu dem einen Meßwerteingang E103a der ersten innenliegenden Strommeßeinrichtung 103 über die Datenleitung 112 übertragen. In dieser wird aus ihrem eigenen Strommeßwert IB und aus dem Meßwert IA der ersten außenliegenden Strommeßeinrichtung 100 ein Summenstrommeßwert IA+IB gebildet, der als Meßwert IA+IB zu dem einen Meßwerteingang E106a der zweiten innenliegenden Strommeßeinrichtung 106 übertragen wird. In der zweiten innenliegenden Strommeßeinrichtung 106 wird aus dem Meßwert IA+IB und ihrem eigenen Strommeßwert IC ein neuer Summenstrommeßwert IA+IB+IC gebildet, der als Meßwert zu dem einen Meßwerteingang E109a der zweiten außenliegenden Strommeßeinrichtung 109 übermittelt wird. In dieser Strommeßeinrichtung 109 wird aus dem Meßwert IA+IB+IC und ihrem eigenen Strommeßwert ID ein Gesamtstromwert IA+IB+IC+ID gebildet; die Strommeßeinrichtung 109 erzeugt an einem nicht dargestellten Steuerausgang ein Fehlersignal S für einen Fehlerstrom, wenn der Gesamtstromwert IA+IB+IC+ID ungleich Null ist bzw. einen vorgegebenen Schwellenwert überschreitet.

Gleichzeitig wird der Strommeßwert ID der zweiten außenliegenden Strommeßeinrichtung 109 als weiterer Meßwert zu dem weiteren Meßwerteingang E106b der zweiten innenliegenden Strommeßeinrichtung 106 übertragen. In der zweiten innenliegenden Strommeßeinrichtung 106 liegt nun also an dem einen Meßwerteingang E106a der eine Meßwert IA+IB der ersten innenliegenden Strommeßeinrichtung 103 und an dem weiteren Meßwerteingang E106b der weitere Meßwert ID vor. Aus den beiden Meßwerten und ihrem eigenen gemessenen Strommeßwert IC wird in der Strommeßeinrichtung 106 der Gesamtstromwert IA+IB+IC+ID gebildet, und es wird das Fehlersignal gebildet, sobald der Gesamtstromwert IA+IB+IC+ID ungleich Null ist bzw. den vorgegebenen Schwellenwert überschreitet; das Fehlersignal S wird dann an einem nicht dargestellten Steuerausgang abgegeben. In der Strommeßeinrichtung 106 wird aus dem an dem weiteren Meßwerteingang E106b anliegenden weiteren Meßwert ID und ihrem eigenen Strommeßwert IC außerdem ein weiterer Summenstrommeßwert IC+ID gebildet, der an dem weiteren Meßwertausgang A106b abgegeben und zu der ersten innenliegenden Strommeßeinrichtung 103 übertragen wird.

In der ersten innenliegenden Strommeßeinrichtung 103 liegt nun an dem einen Meßwerteingang E103a der eine Meßwert IA der ersten außenliegenden Strommeßeinrichtung 100 und an dem weiteren Meßwerteingang E103b der weitere Meßwert IC+ID vor. Aus den beiden Meßwerten IA und IC+ID und ihrem eigenen gemessenen Strommeßwert IB wird in der Strommeßeinrichtung 103 der Gesamtstromwert IA+IB+IC+ID gebildet, und es wird das Fehlersignal gebildet, sobald der Gesamtstromwert IA+IB+IC+ID ungleich Null ist bzw. den vorgegebenen Schwellenwert überschreitet; das Fehlersignal S wird dann an einem nicht dargestellten Steuerausgang abgegeben. In der Strommeßeinrichtung 103 wird aus dem an dem weiteren Meßwerteingang E103b anliegenden weiteren Meßwert IC+ID und dem eigenen Strommeßwert IB außerdem ein weiterer Summenstrommeßwert IB+IC+ID gebildet, der an dem weiteren Meßwertausgang A103b zu der ersten außenliegenden Strommeßeinrichtung 100 abgegeben wird.

In der ersten außenliegenden Strommeßeinrichtung 100 liegt nun an dem Meßwerteingang E100b der Meßwert IB+IC+ID der ersten innenliegenden Strommeßeinrichtung 103 vor. Aus dem Meßwert IB+IC+ID und dem eigenen gemessenen Strommeßwert IA wird in der ersten außenliegenden Strommeßeinrichtung 100 der Gesamtstromwert IA+IB+IC+ID gebildet, und es wird das Fehlersignal gebildet, sobald der Gesamtstromwert IA+IB+IC+ID ungleich Null ist bzw. den vorgegebenen Schwellenwert überschreitet; das Fehlersignal S wird dann an einem nicht dargestellten Steuerausgang abgegeben.

Zusammengefaßt werden also zu jeder der Strommeßeinrichtungen ein Meßwert bzw. zwei Meßwerte übertragen, mit denen jede der Strommeßeinrichtungen in der Lage ist, unter Heranziehung des eigenen Strommeßwertes den Gesamtstromwert zu ermitteln und das Fehlersignal zu erzeugen.

Über die weitere Datenleitung 115 wird zwischen den beiden außenliegenden Strommeßeinrichtungen 100 und 109 jeweils der Gesamtstromwert zu Kontrollzwecken übermittelt; dazu wird in den beiden Strommeßeinrichtung geprüft, ob der von der jeweils anderen außenliegenden Strommeßeinrichtung übermittelte Gesamtstromwert dem eigenen Gesamtstromwert entspricht. Falls dies nicht der Fall sein sollte, wird ein Alarmsignal erzeugt, das einen Fehler in der Meßanordnung angibt. Ein weiterer Vorteil der weiteren Latenleitung 115 besteht darin, daß die Anordnung gemäß Figur 2 auch dann weiterbetrieben werden kann, wenn eine Datenleitung 112 zwischen zwei benachbarten Strommeßeinrichtungen unterbrochen ist, weil in einem solchen Fall die weitere Datenleitung 115 als Ersatz für die unterbrochene Datenleitung 112 verwendet werden kann.

Die eine und die weitere Recheneinheit können beispielsweise durch eine DV-Anlage bzw. durch eine Mikroprozessoranordnung gebildet sein.

Figur 3 zeigt ein Ausführungsbeispiel für eine Strommeßeinrichtung, wie sie in den Anordnungen gemäß Figur 1 und 2 eingesetzt werden kann; dabei wird für die Erläuterung von der Strommeßeinrichtung 103 gemäß Figur 2 ausgegangen, und es werden zur Vereinfachung des Verständnisses der Figur 3 für bereits im Zusammenhang mit der Figur 2 erläuterte Komponenten in der Figur 3 die gleichen Bezugszeichen wie in der Figur 2 verwendet.

Die Strommeßeinrichtung 103 weist einen Stromeingang I103a und einen weiteren Stromeingang I103b auf, mit denen die Strommeßeinrichtung 103 an das Leiterende 123 des Leiters 130 gemäß Figur 2 angeschlossen ist. Mit den beiden Stromeingängen I103a und I103b ist eine Meßeinheit 73 verbunden, der ein Addierglied 76 als Recheneinheit mit einem Eingang E76a, ein weiteres Addierglied 77 als weitere Recheneinheit mit einem Eingang E77a und eine Steuereinheit 78 mit einem Eingang E78a nachgeordnet ist. Das Addierglied 76 ist mit einem weiteren Eingang E76b mit dem einen Meßwerteingang E103a der Strommeßeinrichtung 103 und mit einem Ausgang A76 mit dem einen Meßwertausgang A103a der Strommeßeinrichtung 103 verbunden.

Das weitere Addierglied 77 ist mit einem weiteren Eingang E77b an den weiteren Meßwerteingang E103b der Strommeßeinrichtung 103 und mit einem Ausgang A77 an den weiteren Meßwertausgang A103b der Strommeßeinrichtung 103 angeschlossen.

Ein weiterer Eingang E78b der Steuereinheit 78 ist an den einen Meßwerteingang E103a der Strommeßeinrichtung 103 angeschlossen; ein zusätzlicher Meßwerteingang E78c der Steuereinheit 78 ist mit dem weiteren Meßwerteingang E103b der Strommeßeinrichtung 103 verbunden.

Mit der Meßeinheit 73 wird der Strom IB' im Leiterende 123 gemessen und ein dem Strom IB' entsprechender Strommeßwert IB gebildet. Dieser gelangt zu der Recheneinheit 76, in der aus diesem und dem einen Meßwert IA an dem einen Meßwerteingang E103a ein Summenstrommeßwert IA+IB gebildet und dieser als Meßwert zu dem einen Meßwertausgang A103a der Strommeßeinrichtung 103 übertragen wird.

Der Strommeßwert IB gelangt auch zu dem weiteren Addierglied 77, in dem aus dem weiteren Meßwert IC+ID an dem weiteren Meßwerteingang E103b der Strommeßeinrichtung 103 und dem Strommeßwert IB ein weiterer Summenstrommeßwert IB+IC+ID gebildet und als Meßwert an dem weiteren Meßwertausgang A103b der Strommeßeinrichtung 103 abgegeben wird.

Außerdem wird der Strommeßwert IB zu der Steuereinheit 78 übertragen, in der aus dem eigenen Strommeßwert IB, dem einen Meßwert IA und dem weiteren Meßwert IC+ID ein Gesamtstromwert IA+IB+IC+ID gebildet wird.

In der Steuereinheit 78 wird dieser Gesamtstromwert IA+...+ID mit einem vorgegebenen Schwellenwert, der ungefähr gleich Null ist, verglichen. Überschreitet der Gesamtstromwert den vorgegebenen Schwellenwert, so wird an einem Steuersignalausgang S103 der Strommeßeinrichtung 103 ein Signal S abgegeben, das einen Fehlerstrom in dem Leiter 130 kennzeichnet.

Die Strommeßeinrichtung 103 weist außerdem einen Anschluß Q1 auf, der mit der Steuereinheit 78 verbunden ist. Falls die Strommeßeinrichtung 103 als außenliegende Strommeßeinrichtung 100 bzw. 109 gemäß Figur 2 betrieben werden soll, kann die Strommeßeinrichtung über diesen Anschluß Q1 mit der jeweils anderen außenliegenden Strommeßeinrichtung über die weitere Datenleitung 115 zur Übertragung des Gesamtstromwertes IA+...+ID verbunden werden. In der Steuereinheit 78 wird dann verglichen, ob der eigene Gesamtstromwert gleich dem übertragenen Gesamtstromwert der anderen außenliegenden Strommeßeinrichtung ist. Falls dies nicht der Fall sein sollte, wird an einem weiteren Anschluß Q2 ein Alarmsignal A abgegeben, das angibt, daß ein Fehler in der Meßanordnung aufgetreten ist.

Die eine und die weitere Recheneinheit 76 und 77 sowie die Steuereinheit 78 können durch eine DV-Anlage, beispielsweise eine Mikroprozessoranordnung gebildet sein.

## Patentansprüche

1. Verfahren zum Erzeugen eines einen Fehlerstrom eines mindestens drei Leiterenden (120, 123, 126, 129) aufweisenden elektrischen Leiters (130) kennzeichnenden Fehlersignals mit Strommeßeinrichtungen (100, 103, 106, 109), die derart angeordnet sind, daß an jedem Leiterende des Leiters eine der Strommeßeinrichtungen angebracht ist und die Strommeßeinrichtungen über Datenleitungen (112) verbunden sind, wobei bei dem Verfahren
- mit den Strommeßeinrichtungen der Strom (IA', IB', IC', ID')in den jeweiligen Leiterenden unter Bildung von Strommeßwerten (IA, IB, IC, ID) gemessen wird,
- zu einer ausgewählten Strommeßeinrichtung (109) ein Meßwert (IA+IB+IC) übertragen wird, der aus den Strommeßwerten der übrigen Strommeßeinrichtungen durch vorzeichenrichtige Addition gebildet ist, und
- mit der ausgewählten Strommeßeinrichtung (109) aus ihren Strommeßwerten (ID) und dem Meßwert (IA+IB+IC) ein Gesamtstromwert (IA+IB+IC+ID) durch vorzeichenrichtige Addition gebildet wird und
- mit der ausgewählten Strommeßeinrichtung (109) das Fehlersignal erzeugt wird, wenn der Gesamtstromwert betragsmäßig einen vorgegebenen Schwellenwert überschreitet.

2. Verfahren zum Erzeugen eines einen Fehlerstrom eines mindestens drei Leiterenden (9, 12, 15, 18, 21) aufweisenden elektrischen Leiters (6) kennzeichnenden Fehlersignals mit Strommeßeinrichtungen (30, 33, 36, 39 42), die derart angeordnet sind , daß an jedem Leiterende des Leiters eine der Strommeßeinrichtungen angebracht ist und die Strommeßeinrichtungen über Datenleitungen verbunden sind, wobei bei dem Verfahren
- mit den Strommeßeinrichtungen der Strom (IA', IB', IC', ID', IE') in den jeweiligen Leiterenden unter Bildung von Strommeßwerten (IA, IB, IC, ID, IE) gemessen wird,
- zu einer ausgewählten Strommeßeinrichtung (30) ein Meßwert übertragen wird, der aus den Strommeßwerten (IB+IC) einer ersten Gruppe der übrigen Strommeßeinrichtungen durch vorzeichenrichtige Addition gebildet ist,
- zu der ausgewählten Strommeßeinrichtung ein weiterer Meßwert (ID+IE) übertragen wird, der aus den Strommeßwerten einer zweiten Gruppe der übrigen Strommeßeinrichtungen durch vorzeichenrichtige Addition gebildet ist, wobei die zweite Gruppe alle Strommeßeinrichtungen außer der ausgewählten und den Strommeßeinrichtungen der ersten Gruppe enthält,
- mit der ausgewählten Strommeßeinrichtung (30) aus ihren Strommeßwerten (IA) und den beiden Meßwerten (IB+IC, ID+IE) ein Gesamtstromwert (IA+...+IE) durch vorzeichenrichtige Addition gebildet wird und
- mit der ausgewählten Strommeßeinrichtung (30) das Fehlersignal erzeugt wird, wenn der Gesamtstromwert (IA+...+IE) betragsmäßig einen vorgegebenen Schwellenwert überschreitet.

3. Anordnung zum Erzeugen eines einen Fehlerstrom eines mindestens drei Leiterenden (120, 123, 126, 129) aufweisenden elektrischen Leiters (130) kennzeichnenden Fehlersignals mit an jedem Leiterende des Leiters jeweils einer angebrachten Strommeßeinrichtung (100, 103, 106, 109), die den Strom (IA', IB', IC', ID') in ihrem jeweiligen Leiterende unter Bildung eines Strommeßwertes (IA, IB, IC, ID) mißt, wobei bei der Anordnung
- die Strommeßeinrichtungen elektrisch mittels Datenleitungen (112) in einer kettenförmigen Struktur derart untereinander verbunden sind, daß
- die Strommeßeinrichtungen elektrisch mittels Datenleitungen (112) in einer kettenförmigen Struktur derart untereinander verbunden sind, daß
- jede in der Kette innenliegende Strommeßeinrichtung (103, 106) mit einem Meßwerteingang (E103a, E106a) an einen Meßwertausgang (A100a, A103a) der ihr jeweils vorgeordneten Strommeßeinrichtung und mit einem Meßwertausgang (A103a, A106a) an einen Meßwerteingang (E106a, E109a) der ihr jeweils nachgeordneten Strommeßeinrichtung angeschlossen ist und
- eine erste der beiden in der Kette außenliegenden Strommeßeinrichtungen (100) mit ihrem Meßwertausgang (A100a) an einen Meßwerteingang (E103a) der ihr nachgeordneten innenliegenden Strommeßeinrichtung (103) angeschlossen ist und die zweite der beiden außenliegenden Strommeßeinrichtungen (109) mit einem Meßwerteingang (E109a) an den Meßwertausgang (A106a) der ihr vorgeordneten innenliegenden Strommeßeinrichtung (106) angeschlossen ist,
- jede innenliegende Strommeßeinrichtung (103, 106) eine Recheneinheit aufweist, die ihren Strommeßwert zu einem an ihrem Meßwerteingang anliegenden Meßwert der jeweils vorgeordneten Strommeßeinrichtung (100, 103) vorzeichenrichtig unter Bildung eines Summenstrommeßwertes addiert und den Summenstrommeßwert an ihrem Meßwertausgang als Meßwert abgibt,
- die zweite außenliegende Strommeßeinrichtung (109) eine Steuereinheit aufweist, die das Fehlersignal abgibt, sobald ein aus dem Meßwert (IA+IB+IC) der vorgeordneten innenliegenden Strommeßeinrichtung (106) und ihrem Strommeßwert (ID) durch vorzeichenrichtige Addition gebildeter Gesamtstromwert (IA+...ID) einen vorgegebenen Schwellenwert überschreitet.

4. Anordnung nach Anspruch 3,
**dadurch gekennzeichnet, daß**
- die innenliegenden Strommeßeinrichtungen (103, 106) untereinander derart verbunden sind, daß ein weiterer Meßwerteingang (E103b) einer innenliegenden Strommeßeinrichtung (103) an einen weiteren Meßwertausgang (A106b) der ihr jeweils nachgeordneten innenliegenden Strommeßeinrichtung (106) und ein weiterer Meßwertausgang (A103a) dieser innenliegenden Strommeßeinrichtung (103) an einen weiteren Meßwerteingang (E106a) der ihr jeweils nachgeordneten innenliegenden Strommeßeinrichtung (106) angeschlossen ist,
- die erste außenliegende Strommeßeinrichtung (100) mit einem Meßwerteingang (E100b) an einen weiteren Meßwertausgang (A103b) der ihr nachgeordneten innenliegenden Strommeßeinrichtung (103) angeschlossen ist und die zweite außenliegende Strommeßeinrichtung (109) mit einem Meßwertausgang (A109b) an einen weiteren Meßwerteingang (E106b) der ihr vorgeordneten innenliegenden Strommeßeinrichtung (106) angeschlossen ist,
- jede innenliegende Strommeßeinrichtung (103, 106) eine weitere Recheneinheit aufweist, die den Strommeßwert der eigenen Strommeßeinrichtung zu einem an ihrem weiteren Meßwerteingang (E103b) anliegenden weiteren Meßwert der nachgeordneten Strommeßeinrichtung (106) vorzeichenrichtig unter Bildung eines weiteren Summenstrommeßwertes addiert und den resultierenden weiteren Summenstrommeßwert an ihrem weiteren Meßwertausgang (A103b) als weiteren Meßwert abgibt, und
- mindestens eine der inneren Strommeßeinrichtungen (103, 106) eine Steuereinheit aufweist, die das Fehlersignal erzeugt, sobald der aus den an ihren beiden Meßwerteingängen (E103a, E103b) anliegenden Meßwerten und ihrem gemessenen Strommeßwert durch vorzeichenrichtige Addition gebildete Gesamtstromwert den vorgegebenen Schwellenwert überschreitet.

5. Anordnung nach Anspruch 4,
**dadurch gekennzeichnet, daß**
- die erste außenliegende Strommeßeinrichtung (100) eine Steuereinheit aufweist, die das Fehlersignal erzeugt, sobald der aus dem an ihrem Meßwerteingang (E100b) anliegenden Meßwert und ihrem gemessenen Strommeßwert durch vorzeichen
- richtige Addition gebildete Gesamtstromwert den vorgegebenen Schwellenwert überschreitet.

6. Anordnung nach einem der Ansprüche 3 bis 5,
**dadurch gekennzeichnet, daß**
die beiden außenliegenden Strommeßeinrichtungen (100, 109) durch mindestens eine zusätzliche Datenleitung (115) miteinander verbunden sind, über die der Gesamtstromwert übertragen wird.

7. Strommeßeinrichtung (103) zum Messen eines Stromes (IB') in einem Leiter (123) mit mindestens einem Meßwerteingang (E103a) und mindestens einem Meßwertausgang (A103a) sowie
- einer mit dem mindestens einen Meßwerteingang (E103a) und dem mindestens einen Meßwertausgang (A103a) in Verbindung stehenden Recheneinheit, die einen dem Strom (IB') entsprechenden Strommeßwert (IB) zu einem an dem mindestens einen Meßwerteingang (E103a) anliegenden Meßwert (IA) addiert und
- die den resultierenden Summenstrommeßwert (IA+IB) an dem mindestens einen Meßwertausgang (A103a) abgibt.

8. Strommeßeinrichtung nach Anspruch 7,
**- dadurch gekennzeichnet, daß**
die Recheneinheit eine Einrichtung aufweist, mit der das Vorzeichen des Strommeßwertes geändert werden kann.

9. Strommeßeinrichtung nach einem der Ansprüche 7 oder 8,
**gekennzeichnet durch,**
- eine mit der Recheneinheit verbundene Steuereinheit (78), die ein Signal (S) für einen Fehlerstrom abgibt, sobald ein mit dem Strommeßwert (IB) und dem Meßwert (IA) gebildeter Gesamtstromwert einen vorgegebenen Schwellenwert überschreitet.

## Claims

1. Method for generating a fault signal which characterizes a fault current in an electric conductor (130) having at least three ends (120, 123, 126, 129), using current measuring devices (100, 103, 106, 109) which are arranged in such a way that one of the current measuring devices is fitted to each end of the conductor and the current measuring devices are connected via data lines (112), in the method
- the current measuring devices being used to measure the current (IA', IB', IC', ID') in the respective conductor ends, forming measured current values (IA, IB, IC, ID),
- a measured value (IA+IB+IC), which is formed from the measured current values of the other current measuring devices by addition with the correct sign, being transmitted to a selected current measuring device (109), and
- the selected current measuring device (109) being used to form a total current value (IA+IB+IC+ID) from its measured current values (ID) and the measured value (IA+IB+IC), by addition with the correct sign, and
- the selected current measuring device (109) being used to generate the fault signal if the magnitude of the total current value exceeds a predefined threshold value.

2. Method for generating a fault signal which characterizes a fault current in an electric conductor (6) having at least three ends (9, 12, 15, 18, 21), using current measuring devices (30, 33, 36, 39, 42) which are arranged in such a way that one of the current measuring devices is fitted to each end of the conductor and the current measuring devices are connected via data lines, in the method
- the current measuring devices being used to measure the current (IA', IB', IC', ID', IE') in the respective conductor ends, forming measured current values (IA, IB, IC, ID, IE),
- a measured value which is formed from the measured current values (IB+IC) of a first group of the remaining current measuring devices by addition with the correct sign being transmitted to a selected current measuring device (30),
- a further measured value (ID+IE), which is formed from the measured current values of a second group of the other current measuring devices by addition with the correct sign, being transmitted to the selected current measuring device, the second group containing all the current measuring devices except the selected one and the current measuring devices of the first group,
- the selected current measuring device (30) being used to form a total current value (IA+...+IE) from its measured current values (IA) and the two measured values (IB+IC, ID+IE) by addition with the correct sign, and
- the selected current measuring device (30) being used to generate the fault signal if the magnitude of the total current value (IA+...+IE) exceeds a predefined threshold value.

3. Arrangement for generating a fault signal which characterizes a fault current in an electric conductor (130) having at least three ends (120, 123, 126, 129), using a current measuring device (100, 103, 106, 109) which in each case is fitted to each of the conductor ends and measures the current (IA', IB', IC', ID') in its respective conductor end, forming a measured current value (IA, IB, IC, ID), in the arrangement
- the current measuring devices being electrically interconnected by means of data lines (112) in a chain structure in such a way that
- each inner current measuring device (103, 106) in the chain is connected, by a measured-value input (E103a, E106a), to a measured-value output (A100a, A103a) of the current measuring device respectively arranged before it and, by a measured-value output (A103a, A106a), to a measured-value input (E106a, E109a) of the current measuring device respectively arranged after it, and
- a first of the two outer current measuring devices (100) in the chain is connected, by its measured-value output (A100a), to a measured-value input (E103a) of the inner current measuring device (103) arranged after it, and the second of the two outer current measuring devices (109) is connected, by a measured-value input (E109a), to the measured-value output (A106a) of the inner current measuring device (106) arranged before it,
- each inner current measuring device (103, 106) having a computing unit which adds its measured current value to a measured value across its measured-value input and coming from the current measuring device (100, 103) respectively arranged before it, with the correct sign, forming a summed measured current value, and outputting the summed measured current value at its measured-value output as a measured value,
- the second outer current measuring device (109) having a control unit which outputs the fault signal as soon as a total current value (IA+...+ID), formed from the measured value (IA+IB+IC) of the inner current measuring device (106) arranged before it and the measured current value (ID) from the latter by addition with the correct sign, exceeds a predefined threshold value.

4. Arrangement according to Claim 3, **characterized in that**
- the inner current measuring devices (103, 106) are interconnected in such a way that a further measured-value input (E103b) of an inner current measuring device (103) is connected to a further measured-value output (A106b) of the inner current measuring device (106) respectively arranged after it, and a further measured-value output (A103a) of this inner current measuring device (103) is connected to a further measured-value input (E106a) of the inner current measuring device (106) respectively arranged after it,
- the first outer current measuring device (100) is connected, by a measured-value input (E100b), to a further measured-value output (A103b) of the inner current measuring device (103) arranged after it, and the second outer current measuring device (109) is connected, by a measured-value output (A109b), to a further measured-value input (E106b) of the inner current measuring device (106) arranged before it,
- each inner current measuring device (103, 106) has a further computing unit, which adds the measured current value from its own current measuring device to a further measured value, across its further measured-value input (E103b), from the current measuring device (106) arranged after it, with the correct sign, forming a further summed measured current value, and outputs the resulting further summed measured current value at its further measured-value output (A103b), as a further measured value, and
- at least one of the inner current measuring devices (103, 106) has a control unit which generates the fault signal as soon as the total current value, formed from the measured values across its two measured-value inputs (E103a, E103b) and its measured current value by addition with the correct sign, exceeds the predefined threshold value.

5. Arrangement according to Claim 4, **characterized in that**
- the first outer current measuring device (100) has a control unit which generates the fault signal as soon as the total current value, formed from the measured value across its measured-value input (E100b) and its measured current value by addition with the correct sign, exceeds the predefined threshold value.

6. Arrangement according to one of Claims 3 to 5, **characterized in that** the two outer current measuring devices (100, 109) are interconnected by at least one additional data line (115), via which the total current value is transmitted.

7. Current measuring device (103) for measuring a current (IB') in a conductor (123), having at least one measured-value input (E103a) and at least one measured-value output (A103a), and
- a computing unit which is connected to the at least one measured-value input (E103a) and the at least one measured-value output (A103a) and which adds a measured current value (IB) corresponding to the current (IB') to a measured value (IA) across the at least one measured-value input (E103a), and
- which outputs the resulting summed measured current value (IA+IB) at the at least one measured-value output (A103a).

8. Current measuring device according to Claim 7,
- **characterized in that** the computing unit has a device with which the sign of the measured current value can be changed.

9. Current measuring device according to either of Claims 7 and 8, **characterized by**
- a control unit (78) which is connected to the computing unit and which outputs a signal (S) for a fault current as soon as a total current value, formed with the measured current value (IB) and the measured value (IA), exceeds a predefined threshold value.

## Revendications

1. Procédé pour produire un signal d'erreur, caractérisant un courant de défaut d'un conducteur électrique (130) comportant au moins trois extrémités de conducteur (120, 123, 126, 129), avec des dispositifs de mesure de courant (100, 103, 106, 109) qui sont placés de telle sorte que l'un des dispositifs de mesure de courant est mis à chaque extrémité du conducteur et que les dispositifs de mesure de courant sont reliés par l'intermédiaire de lignes de données (112), dans lequel, pour le procédé,
- avec les dispositifs de mesure de courant, on mesure le courant (IA', IB', IC', ID') dans les extrémités de conducteur respectives en formant des valeurs mesurées de courant (IA, IB, IC, ID),
- à un dispositif de mesure de courant sélectionné (109), on transmet une valeur mesurée (IA + IB + IC) qui est formée par addition signée à partir des valeurs mesurées de courant des autres dispositifs de mesure de courant, et
- avec le dispositif de mesure de courant sélectionné (109), on forme par addition signée à partir de ses valeurs mesurées de courant (ID) et de la valeur mesurée (IA + IB + IC) une valeur de courant totale (IA + IB + IC + ID) et
- avec le dispositif de mesure de courant sélectionné (109), on produit le signal d'erreur lorsque la valeur de courant totale dépasse en valeur absolue une valeur de seuil prédéterminée.

2. Procédé pour produire un signal d'erreur, caractérisant un courant de défaut d'un conducteur électrique (6) comportant au moins trois extrémités de conducteur (9, 12, 15, 18, 21), avec des dispositifs de mesure de courant (30, 33, 36, 39, 42) qui sont placés de telle sorte que l'un des dispositifs de mesure de courant est mis à chaque extrémité du conducteur et que les dispositifs de mesure de courant sont reliés par l'intermédiaire de lignes de données, dans lequel, pour le procédé,
- avec les dispositifs de mesure de courant, on mesure le courant (IA', IB', IC', ID', IE') dans les extrémités de conducteur respectives en formant des valeurs mesurées de courant (IA, IB, IC, ID, IE),
- à un dispositif de mesure de courant sélectionné (30), on transmet une valeur mesurée qui est formée par addition signée à partir des valeurs mesurées de courant (IB + IC) d'un premier groupe des autres dispositifs de mesure de courant,
- à un dispositif de mesure de courant sélectionné, on transmet une autre valeur mesurée (ID + IE) qui est formée par addition signée à partir des valeurs mesurées de courant d'un deuxième groupe des autres dispositifs de mesure de courant, le deuxième groupe contenant alors tous les dispositifs de mesure de courant hormis le dispositif de mesure de courant sélectionné et les dispositifs de mesure de courant du premier groupe,
- avec le dispositif de mesure de courant sélectionné (30), on forme par addition signée à partir de ses valeurs mesurées de courant (IA) et des deux valeurs mesurées (IB + IC, ID + IE) une valeur de courant totale (IA + ... + IE) et
- avec le dispositif de mesure de courant sélectionné (30), on produit le signal d'erreur lorsque la valeur de courant totale (IA + ... + IE) dépasse en valeur absolue une valeur de seuil prédéterminée.

3. Dispositif pour produire un signal d'erreur, caractérisant un courant de défaut d'un conducteur électrique (130) comportant au moins trois extrémités de conducteur (120, 123, 126, 129), avec un dispositif de mesure de courant (100, 103, 106, 109) qui est placé à chaque extrémité du conducteur et qui mesure le courant (IA', IB', IC', ID') dans son extrémité de conducteur respective en formant une valeur mesurée de courant (IA, IB, IC, ID), dans lequel, pour le dispositif,
- les dispositifs de mesure de courant sont reliés électriquement entre eux au moyen de lignes de données (112) en une structure en forme de chaîne de telle sorte que
- chaque dispositif de mesure de courant (103, 106) se trouvant à l'intérieur dans la chaîne est raccordé par une entrée de valeur mesurée (E103a, E106a) à une sortie de valeur mesurée (A100a, A103a) du dispositif de mesure de courant qui se trouve respectivement du côté amont de lui et par une sortie de valeur mesurée (A103a, A106a) à une entrée de valeur mesurée (E106a, E109a) du dispositif de mesure de courant qui se trouve respectivement du côté aval de lui, et
- un premier (100) des deux dispositifs de mesure de courant se trouvant à l'extérieur dans la chaîne est raccordé par sa sortie de valeur mesurée (A100a) à une entrée de valeur mesurée (E103a) du dispositif de mesure de courant (103) se trouvant à l'intérieur du côté aval de lui et le deuxième (109) des deux dispositifs de mesure de courant se trouvant à l'extérieur est raccordé par une entrée de valeur mesurée (E109a) à la sortie de valeur mesurée (A106a) du dispositif de mesure de courant (106) se trouvant à l'intérieur du côté amont de lui,
- chaque dispositif de mesure de courant se trouvant à l'intérieur (103, 106) comporte une unité de calcul qui ajoute en tenant compte des signes sa valeur mesurée de courant à une valeur mesurée présente à son entrée de valeur mesurée et correspondant au dispositif de mesure de courant respectivement du côté amont (100, 103) en formant une valeur mesurée de courant cumulée et il délivre la valeur mesurée de courant cumulée comme valeur mesurée à sa sortie de valeur mesurée,
- le deuxième dispositif de mesure de courant se trouvant à l'extérieur (109) comporte une unité de commande qui délivre le signal d'erreur dès qu'une valeur de courant totale (IA + ... + ID) formée par addition signée à partir de la valeur mesurée (IA + IB + IC) du dispositif de mesure de courant se trouvant à l'intérieur du côté amont (106) et de sa valeur mesurée de courant (ID) dépasse une valeur de seuil prédéterminée.

4. Dispositif selon la revendication 3,
**caractérisé par le fait que**
- les dispositifs de mesure de courant se trouvant à l'intérieur (103, 106) sont reliés entre eux de telle sorte qu'une autre entrée de valeur mesurée (E103b) d'un dispositif de mesure de courant se trouvant à l'intérieur (103) est raccordée à une autre sortie de valeur mesurée (A106b) du dispositif de mesure de courant se trouvant à l'intérieur respectivement du côté aval de lui (106) et qu'une autre sortie de valeur mesurée (A103a) de ce dispositif de mesure de courant se trouvant à l'intérieur (103) est raccordée à une autre entrée de valeur mesurée (E106a) du dispositif de mesure de courant se trouvant à l'intérieur respectivement du côté aval de lui (106),
- le premier dispositif de mesure de courant se trouvant à l'extérieur (100) est raccordé par une entrée de valeur mesurée (E100b) à une autre sortie de valeur mesurée (A103b) du dispositif de mesure de courant se trouvant à l'intérieur du côté aval de lui (103) et le deuxième dispositif de mesure de courant se trouvant à l'extérieur (109) est raccordé par une sortie de valeur mesurée (A109b) à une autre entrée de valeur mesurée (E106b) du dispositif de mesure de courant se trouvant à l'intérieur du côté amont de lui (106),
- chaque dispositif de mesure de courant se trouvant à l'intérieur (103, 106) comporte une unité de calcul qui ajoute en tenant compte des signes la valeur mesurée de courant du propre dispositif de mesure de courant à une autre valeur mesurée présente à son autre entrée de valeur mesurée (E103b) et correspondant au dispositif de mesure de courant du côté aval (106) en formant une autre valeur mesurée de courant cumulée et il délivre l'autre valeur mesurée de courant cumulée résultante comme autre valeur mesurée à son autre sortie de valeur mesurée (A103b), et
- au moins l'un des dispositifs de mesure de courant se trouvant à l'intérieur (103, 106) comporte une unité de commande qui produit le signal d'erreur dès que la valeur de courant totale formée par addition signée à partir des valeurs mesurées présentes à ses deux entrées de valeur mesurée (E103a, E103b) et de sa propre valeur mesurée de courant dépasse la valeur de seuil prédéterminée.

5. Dispositif selon la revendication 4,
**caractérisé par le fait que**
- le premier dispositif de mesure de courant se trouvant à l'extérieur (100) comporte une unité de commande qui produit le signal d'erreur dès que la valeur de courant totale formée par addition signée à partir de la valeur mesurée présente à son entrée de valeur mesurée (E100b) et de sa propre valeur mesurée de courant dépasse la valeur de seuil prédéterminée.

6. Dispositif selon l'une des revendications 3 à 5,
**caractérisé par le fait que** les deux dispositifs de mesure de courant se trouvant à l'extérieur (100, 109) sont reliés entre eux par au moins une ligne de données supplémentaire (115) par l'intermédiaire de laquelle la valeur de courant totale est transmise.

7. Dispositif de mesure de courant (103) destiné à mesurer un courant (IB') dans un conducteur (123) et comportant au moins une entrée de valeur mesurée (E103a) et au moins une sortie de valeur mesurée (A103a) ainsi qu'une unité de calcul
- qui est en liaison avec l'entrée ou les entrées de valeur mesurée (E103a) et avec la sortie ou les sorties de valeur mesurée (A103a), qui ajoute une valeur mesurée de courant (IB) correspondant au courant (IB') à une valeur mesurée (IA) présente à l'entrée de valeur mesurée (E103a) et
- qui délivre la valeur mesurée de courant cumulée résultante (IA + IB) à la sortie de valeur mesurée (A103a).

8. Dispositif de mesure de courant selon la revendication 7,
**caractérisé par le fait que** l'unité de calcul comporte un dispositif avec lequel le signe de la valeur mesurée de courant peut être modifié.

9. Dispositif de mesure de courant selon l'une des revendications 7 ou 8,
**caractérisé par**
- une unité de commande (78) qui est reliée à l'unité de calcul et qui délivre un signal (S) pour un courant de défaut dès qu'une valeur de courant totale formée avec la valeur mesurée de courant (IB) et avec la valeur mesurée (IA) dépasse une valeur de seuil prédéterminée.
